# EUROPÄISCHE PATENTSCHRIFT

(11) **EP 0 712 137 B1**
(45) Veröffentlichungstag und Bekanntmachung des Hinweises auf die Patenterteilung: **04.10.2001**
(21) Anmeldenummer: 95117664.3
(22) Anmeldetag: 09.11.1995
(51) Int. Cl.: G11C 17/16, H01L 23/525

(54) **Programmierbarer Halbleiterspeicher**
Programmable semiconductor memory
Mémoire à semi-conducteurs programmable

(30) Priorität: 12.11.1994 DE 4440539
(43) Veröffentlichungstag der Anmeldung: 15.05.1996
(73) Patentinhaber: Micronas GmbH, 79108 Freiburg (DE)
(72) Erfinder: Frerichs, Hans-Peter, Dr. Dipl.-Phys., D-79271 St. Peter (DE)

(56) Entgegenhaltungen:
- US-A- 4 543 594
- US-A- 4 562 639
- US-A- 5 401 993
- A. M. BRACCO ET AL.: "Write Once Read Only Store. October 1970." IBM TECHNICAL DISCLOSURE BULLETIN, Bd. 13, Nr. 5, Oktober 1970, NEW YORK, US, Seite 1308 XP002058273
- BAUMVOL I J R ET AL: "Degradation of very thin gate dielectrics for MOS structures due to through-oxide ion implantation" NUCLEAR INSTRUMENTS & METHODS IN PHYSICS RESEARCH, SECTION - B: BEAM INTERACTIONS WITH MATERIALS AND ATOMS, Bd. 96, Nr. 1/2, März 1995, Seite 92-98 XP004010965

## Beschreibung

Die Erfindung betrifft einen programmierbaren Halbleiterspeicher mit den Merkmalen des Oberbegriffs des Patentanspruchs 1.

Ein solcher Halbleiterspeicher ist bekannt aus: A. M. BRACCO ET AL.: ,Write Once Read Only Store', IBM TECHNICAL DISCLOSURE BULLETIN, Bd. 13, Nr. 5, Oktober 1970, NEW YORK, US, Seite 1308 XP002058273

Da die Komplexität von Halbleiterschaltungen zunimmt, werden immer höhere Anforderungen an deren Flexibilität gestellt. Es ist daher erforderlich, solche Halbleiterschaltungen mit programmierbaren Speichern auszustatten, deren Programmierung erst nach der Herstellung der integrierten Schaltung (IC) vorgenommen werden können. Zu diesem Zweck kann ein EPROM als programmierbarer Speicher benutzt werden. Der Nachteil der Verwendung eines EPROMs besteht darin, daß der Herstellungsprozeß relativ kompliziert und teuer ist und daß der Platzbedarf für eine solche Schaltung relativ groß ist.

Aus der WO 92/20095 ist eine programmierbare Halbleiteranordnung mit programmierbaren Elementen, wie EPROMs oder Gatebereiche bekannt. Diese programmierbaren Elemente können eine Antischmelzzone aufweisen. Eine solche Antischmelzzone besteht aus einem Material, das in einem ersten Zustand, dem nicht programmierten und hochohmigen Zustand, nicht elektrisch leitet und in einem zweiten Zustand, dem programmierten und niederohmigen Zustand, der durch Anlegen einer genügend hohen Spannung erzeugt wird, elektrisch leitet. Die Antischmelzzone wird bei dieser Erfindung dazu benutzt, einen elektrischen Kurzschluß zwischen zwei Leitungsbahnen durch Anlegen einer äußeren Spannung herzustellen.

Aus der US-A-5401993 ist ein programmierbarer Halbleiterspeicher mit einem MOS-Feldeffekttransistor bekannt. Bei dieser Anordnung ist eine Antischmelzzone vorgesehen, welche die Gateelektrode mit der Drainzone verbindet. Durch Anlegen einer Spannung über einen zusätzlichen Kontakt kann eine elektrische Verbindung zwischen der Gateelektrode und der Drainzone hergestellt werden.

Aus der US-A-4562639 ist eine programmierbare Halbleiterschaltung bekannt. Es ist dort eine Drainzone über eine Antischmelzzone mit einer Elektrode verbunden. Diese Anordnung kann mittels eines zusätzlichen Transistors programmiert und ausgelesen werden.

Aus der US-A-4543594 ist eine kondensatorähnliche MOS-Anordnung bekannt, die eine schmelzbare Verbindung aufweist und in einem ROM verwendet werden kann.

Der Erfindung liegt die Aufgabe zugrunde einen programmierbaren Halbleiterspeicher zu schaffen, der in einem MOS-Prozess mit geringem Prozessaufwand herstellbar ist.

Diese Aufgabe wird durch einen programmierbaren Halbleiterspeicher mit den Merkmalen des Patentanspruchs 1 gelöst.

Da die Antischmelzzone mit der Drainzone deckungsgleich ist, braucht man für die Herstellung der Antischmelzzone nur eine zusätzliche Maske. Dadurch wird das Herstellungsverfahren des Halbleiterspeichers vereinfacht und kostengünstiger.

Bei dem erfindungsgemäßen Halbleiterspeicher ist der Transistor aufgrund der Antischmelzzone programmierbar und bildet dessen Basiszelle. Die Programmierung erfolgt durch Anlegen der Programmierspannung. Die Basiszelle bzw. der Transistor kann durch Anlegen einer Spannung, die größer als die Transistorspannung ist, ausgelesen werden. Ist der Transistor programmiert, so besteht wegen der in diesem Zustand niederohmigen Antischmelzzone eine niederohmige Verbindung zwischen der Gateelektrode und dem Drainanschluß des Transistors. In diesem Fall kann ein Strom durch den Transistor fließen und detektiert werden. Ist die Basiszelle bzw. der Transistor nicht programmiert, so wird die Gateelektrode von dem Drainanschluß durch die in diesem Zustand isolierende Antischmelzzone isoliert, so daß kein Strom durch den Transistor fließen kann. Aufgrund der Anordnung der Antischmelzzone zwischen der Gateelektrode und der Drainzone des Transistors wird eine platzsparende Anordnung erreicht. Ferner kann die Antischmelzzone durch Verwendung nur einer zusätzlichen Maske in dem MOS-Prozeß hergestellt werden. Somit ist der Aufwand in dem Herstellungsverfahren gering.

Der erfindungsgemäße Halbleiterspeicher kann auch bei der Anordnung mehrerer programmierbarer Speicher in Form eines Feldes verwendet werden.

Es ist günstig, wenn die Antischmelzzone aus Siliziumdioxid besteht. Bei diesem Material kann die Durchbruchfestigkeit bezüglich einer anliegenden elektrischen Spannung durch eine geeignete Implantation in der sich unter der Antischmelzzone befindenden Zone, hier der Drainzone, in gewissen Grenzen eingestellt werden. Der die Antischmelzzone die Drainzone bedeckt, kann die Durchbruchsfestigkeit der Antischmelzzone über ihren gesamten Bereich durch die Dotierung der Drainzone gleichmäßig eingestellt werden.

Vorteilhafterweise ist die Antischmelzzone dünner als das Gateoxid des Transistors. Dann kann die Antischmelzzone aus dem gleichen Material gebildet werden wie das Gateoxid. Es kann dann bei dem Herstellungsverfahren auch der ganze Flächenbereich des Gateoxids bereits mit dem Material der Antischmelzzone bedeckt werden. Für das dickere Gateoxid wird das Material zusätzlich außerhalb des Bereichs der Antischmelzzone aufgebracht. Durch Anlegen der Programmierspannung an die Antischmelzzone wird diese in ihren niederohmigen Zustand übergeführt, wohingegen das Gateoxid aufgrund seiner größeren Dicke seinen isolierenden Zustand beibehält. Mit der Dicke der Antischmelzzone kann die Druchbruchsfestigkeit derselben in Bezug auf die von außen angelegte Spannung bestimmt werden. Mit zunehmender Dicke der Antischmelzzone nimmt die Durchbruchsfestigkeit und damit die erforderliche Programmierspannung zu. Eine vorteilhafte Dicke der Antischmelzzone liegt zwischen 8 bis 12 nm.

Günstigerweise kann die vorbestimmte Spannungsfestigkeit der Antischmelzzone mit der Dotierung der Drainzone eingestellt werden. Dabei ist es günstig, wenn die Dotierung der Drainzone geringer als die Dotierung der Sourcezone ist. Die Dotierungen können sich typischerweise um einen Faktor 10 unterscheiden. Hierdurch wird verhindert, daß das Gateoxid aufgrund der hohen Dotierung der Sourcezone bei Anliegen der Programmierspannung durchbricht. Eine typische Implant-Dosis für die Drainzone in einem Siliziumsubstrat wäre beispielsweise (2 - 10)×10¹⁴ A/cm², bei der Verwendung von Arsen als Dotierstoff. Die genaue Größe ist ebenfalls von der Implantationsenergie des jeweiligen Inplantierstoffes abhängig. Bei einer Dicke der Antischmelzzone aus Siliziumdioxid zwischen 8 bis 12 nm kann bei einer entsprechenden Dotierung die Programmierspannung bei Strömen von 1 µA zwischen 10 bis 12 V gewählt werden.

Der erfindungsgemäße programmierbare Halbleiterspeicher kann vorteilhafterweise in einer integrierten Schaltungsanordnung (IC) verwendet werden. In einem solchen IC können die Speicher in Form einer Matrix angeordnet sein, wobei den Speichern die Programmierspannung und eine Lesespannung zeilen- bzw. reihenweise zuführbar ist. So kann jeder einzelne Speicher durch Anlegen der Programmierspannung bzw. einer Lesespannung programmiert bzw. ausgelesen werden. Ferner kann an die momentan nicht zu programmierenden Speicher eine die Programmierung verhindernde Gegenspannung anlegbar sein. Dadurch kann jeder Speicher einzeln programmiert werden, ohne daß benachbarte Speicher über eine Verbindungsleitung mitprogrammiert werden.

Im folgenden wird die Erfindung anhand der Figuren näher beschrieben.

Es zeigen:
Fig. 1 eine Draufsicht auf einen erfindungsgemäßen Halbleiterspeicher;
Fig. 2 einen Querschnitt durch den erfindungsgemäßen Halbleiterspeicher entlang der Linie II-II und
Fig. 3 eine Anordnung der erfindungsgemäßen programmierbaren und auslesbaren Speicher in Form einer Matrix.

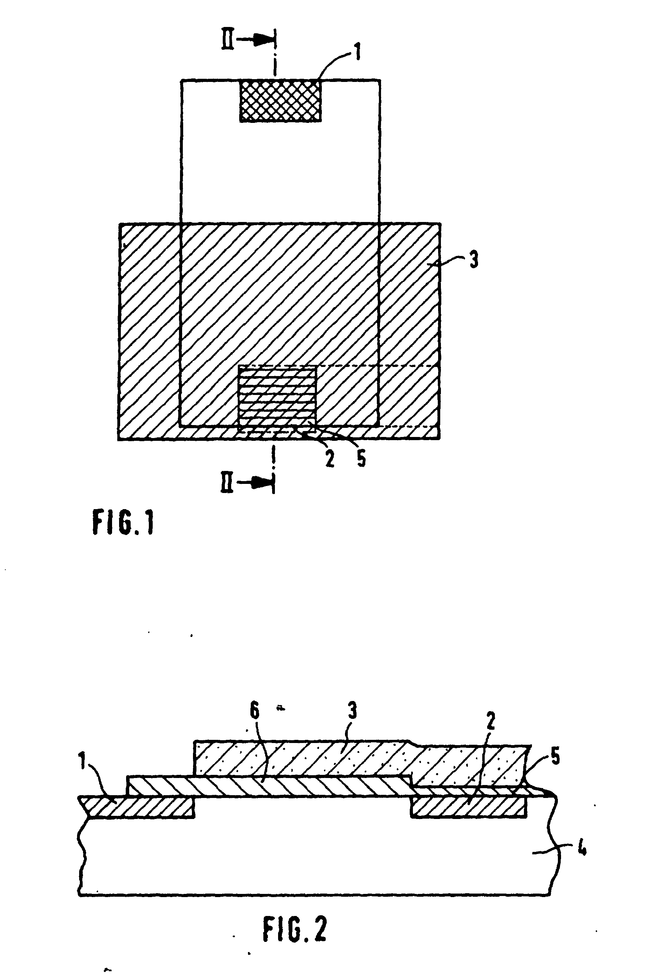

In Fig. 1 und 2 ist ein erfindungsgemäßer programmierbarer Halbleiterspeicher schematisch dargestellt. Es handelt sich dabei um einen Transistor, der eine Sourcezone 1, eine Drainzone 2 und eine Gateelektrode 3 aufweist. Es wird davon ausgegangen, daß es sich bei diesem Transistor um einen n-Kanaltransistor handelt, dessen Substrat 4 p-dotiert ist und dessen Sourcezone 1 und Drainzone 2 n-dotiert sind. Dies bedeutet jedoch keine Einschränkung der Erfindung, da die Erfindung ebenfalls auf einen p-Kanaltransistor anwendbar ist. Zwischen der Drainzone 2 und der Gateelektrode 3 ist eine Antischmelzzone 5 angeordnet. Angrenzend an die Antischmelzzone 5 erstreckt sich ein Gateoxid 6 zwischen der Gateelektrode 3 und dem Substrat 4. Die Antischmelzzone 5 besteht aus einem Material, das vor Anlegen einer Programmierspannung, die größer ist als die Betriebsspannung ist, hochohmig ist und die Drainzone von der Gateelektrode isoliert. Bei Anlegen der Programmierspannung über die Drainzone 2 und die Gateelektrode 3 wird die Antischmelzzone 5 in ihren niederohmigen Zustand überführt. Dadurch entsteht eine elektrisch leitende Verbindung zwischen der Drainzone 2 und der Gateelektrode 3. Der Transistor kann also durch Anlegen der Programmierspannung programmiert werden, so daß er einen Halbleiterspeicher bildet. Durch Anlegen einer Lesespannung kann festgestellt werden, ob dieser Transistor programmiert wurde oder nicht. Wurde der Transistor programmiert, so besteht eine leitende Verbindung zwischen der Drainzone 2 und der Gateelektrode 3 aufgrund des niederohmigen Zustandes der Antischmelzzone 5. Bei Anlegen der Lesespannung fließt dann ein Strom durch den Transistor, welcher nachgewiesen werden kann. Wurde der Transistor nicht programmiert, so ist die Drainzone von der Gateelektrode isoliert und bei Anlegen der Lesespannung fließt kein Strom durch den Transistor.

Die Durchbruchfestigkeit der Antischmelzzone 5 kann durch die Dotierung der Drainzone 2 beeinflußt werden. Je höher die Dotierung der Drainzone 2 ist, desto niedriger ist die Durchbruchfestigkeit der Antischmelzzone 5. Ein weiteres Maß für die Durchbruchfestigkeit der Antischmelzzone 5 ist deren Dicke. Diese ist in der Regel niedriger als die Dicke des Gateoxids 6. Denn so kann das Gateoxid aus dem gleichen Material bestehen wie die Antischmelzzone 5, z.B. aus Siliziumdioxid. Durch Anlegen der Programmierspannung an die Drainzone 2 und die Gateelektrode 3 wird dann zwar der Durchbruch der Antischmelzzone 5 erreicht, es ist dabei jedoch gleichzeitig gewährleistet, daß das Gateoxid 6 nicht durchbricht sondern seinen isolierenden Zustand beibehält. Typische Werte, für die die Speicherfunktion des Transistors gut erfüllt sind, sind 8 bis 12 nm für die Dicke der Antischmelzzone bei der Verwendung von Siliziumdioxid, eine Implantation von 10¹⁴ A/cm² und eine Programmierspannung von 10 bis 12 V bei einem Strom von einem uA. Der erfindungsgemäße Speicher läßt sich aber auch bei anderen Kombinationen dieser Parameter realisieren. In der Regel ist die Dotierung der Drainzone 2 um eine Größenordnung geringer als die Dotierung der Sourcezone 1. Somit wird ein unerwünschtes Durchbrechen der dünnen Antischmelzzone 5 aufgrund einer zu hohen Dotierung verhindert.

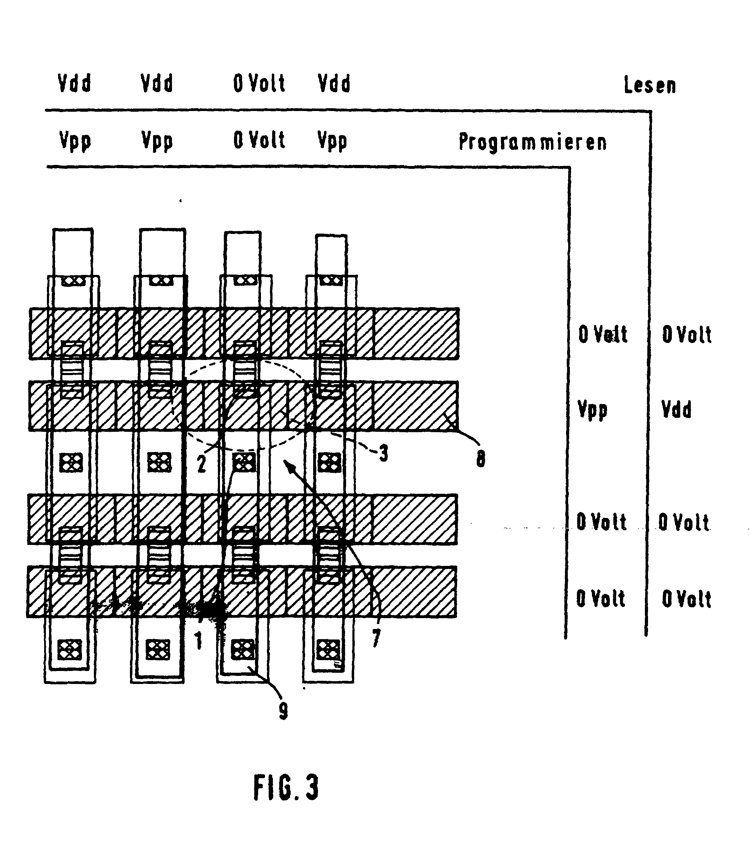

In Fig. 3 ist eine mögliche Anordnung von vier mal vier programmierbaren erfindungsgemäßen Halbleiterspeichern gezeigt. Es sind Spannungswerte zum Programmieren und Lesen eines ausgewählten Transistors 7 gezeigt. Die Programmierspannung bzw. die Lesespannung wird zeilen- bzw. spaltenweise über Metallbahnen zugeführt. Zur Programmierung des ausgewählten Transistors 7 wird der Elektrode einer Zeile 8 eine Programmierspannung Vpp zugeführt, welche dann an der Gateelektrode 3 des Transistors 7 anliegt. Über die Spalte 9 wird der Drainzone 2 des Transistors 7 eine Spannung von 0 V über die Sourcezone 1 zugeführt. Aufgrund der Programmierspannung Vpp geht die Antischmelzzone 5 des Transistors 7 in ihren niederohmigen Zustand über, so daß eine leitende Verbindung zwischen der Drainzone 2 und der Gateelektrode 3 besteht. Durch Zuführen der Spannung von 0 V an die Drainzone 2 des Transistors 7 und durch Anlegen der Lesespannung Vdd an die Gateelektrode 3 des Transistors 7, kann ein Strom durch den Transistor 7 gemessen werden. Dieser kann an der Zeile 8 oder 9 nachgemessen werden. Die an den übrigen Transistoren angelegten Programmierspannungen Vpp verhindern, daß einer dieser umliegenden Transistoren bei der Programmierung des Transistors 7 mitprogrammiert wird. Zum Auslesen des Transistors 7 an der Zeile 8 legt man bei all diesen umliegenden Transistoren an deren Gateelektroden eine Spannung von 0 V und an deren Sourcezone die Lesespannung Vdd an, so daß nur der Stromfluß durch den ausgewählten Transistor abgefragt wird. Legt man an die Sourcezone eine Spannung von 0 V an, so kann der Transistor 7 über die Spalte 9 ausgelesen werden. Gleichzeitig können die in der gleichen Reihe liegenden Transistoren jeweils über die zugehörigen Spalten ausgelesen werden.

Die in den Figuren 1 bis 3 gezeigten Transistoren sind lediglich schematische Darstellungen. Es sind daher ihre Elektrodenanschlüsse und weitere dem Fachmann geläufige Einzelheiten nicht dargestellt.

## Patentansprüche

1. Programmierbarer Halbleiterspeicher mit einem MOS-Feldeffekt-Tranistor, zwischen dessen Gateelektrode (3) und dessen Drainzone (2) eine Antischmelzzone (5) vorgesehen ist, deren Parameter so gewählt sind, daß vor Anlegen einer Programmierspannung (Vpp) die Gateelektrode (3) und die Drainzone (2) durch die Antischmelzzone (5) voneinander isoliert sind und daß durch Anlegen der Programmierspannung (Vpp), die größer als die Betriebsspannung (Vdd) ist, die Antischmelzzone (5) in ihren niederohmigen Zustand übergeht, **dadurch gekennzeichnet, daß** die Antischmelzzone (5) und die Drainzone (2) deckungsgleich sind.

2. Programmierbarer Speicher nach Anspruch 1, **dadurch gekennzeichnet, daß** die Antischmelzzone (5) aus Siliziumdioxid besteht.

3. Programmierbarer Speicher nach einem der vorangehenden Patentansprüche, **dadurch gekennzeichnet, daß** die Antischmelzzone (5) dünner ist als das Gateoxid (6) des Transistors (7).

4. Programmierbarer Speicher nach einem der vorangehenden Patentansprüche, **dadurch gekennzeichnet, daß** die Dicke der Antischmelzzone 8 bis 12 nm beträgt.

5. Programmierbarer Speicher nach einem der vorangehenden Patentansprüche, **dadurch gekennzeichnet, daß** eine vorbestimmte Spannungsfestigkeit der Antischmelzzone (5) mit der Dotierung der Drainzone (2) einstellbar ist.

6. Programmierbarer Speicher nach einem der vorangehenden Patentansprüche, **dadurch gekennzeichnet, daß** die Dotierung der Drainzone (2) geringer ist als die Dotierung der Sourcezone (1) und vorzugsweise 1/10 davon beträgt.

7. Integrierte Schaltungsanordnung mit wenigstens einem programmierbaren Halbleiterspeicher nach einem der vorangehenden Patenansprüche.

8. Integrierte Schaltungsanordnung nach Anspruch 7, **dadurch gekennzeichnet, daß** die Speicher in Form einer Matrix angeordnet sind, wobei den Speichern die Programmmierspannung (Vpp) und eine Lesespannung (Vdd) zeilen-bzw. reihenweise zuführbar ist.

9. Integrierte Schaltungsanordnung nach Anspruch 8, **dadurch gekennzeichnet, daß** an die momentan nicht zu programmierenden Speicher eine die Programmierung verhindernde Gegenspannung (Vpp) anlegbar ist.

## Claims

1. A programmable semiconductor memory comprising an MOS field-effect transistor having between its gate electrode (3) and drain region (2) an antifuse region (5) whose parameters are chosen so that before application of a programming voltage (Vpp), the gate electrode (3) and the drain region (2) are isolated from each other by the antifuse region (5), and that on application of the programming voltage (Vpp), which is greater than the operating voltage (Vdd), the antifuse region (5) changes to its low-impedance state, **characterized in that** the antifuse region (5) and the drain region (2) are congruent.

2. A programmable memory as claimed in claim 1, **characterized in that** the antifuse region (5) is made of silicon dioxide.

3. A programmable memory as claimed in either of the preceding claims, **characterized in that** the antifuse region (5) is thinner than the gate oxide (6) of the transistor (7).

4. A programmable memory as claimed in any one of the preceding claims, **characterized in that** the thickness of the antifuse region is 8 to 12 nm.

5. A programmable memory as claimed in any one of the preceding claims, **characterized in that** a predetermined breakdown strength of the antifuse region (5) is set with the doping level of the drain region (2).

6. A programmable memory as claimed in any one of the preceding claims, **characterized in that** the doping level of the drain region (2) is lower than the doping level of the source region (1), preferably 1/10 thereof.

7. An integrated circuit comprising at least one programmable semiconductor memory as claimed in any one of the preceding claims.

8. An integrated circuit as claimed in claim 7, **characterized in that** the memories are arranged in the form of a matrix, with the programming voltage (Vpp) and a read voltage (Vdd) being applicable to the memories via rows and columns, respectively.

9. An integrated circuit as claimed in claim 8, **characterized in that** a reverse voltage (Vpp) preventing the programming can be applied to the memories currently not to be programmed.

## Revendications

1. Mémoire à semi-conducteurs programmable comportant un transistor à effet de champ de technologie MOS entre l'électrode de grille (3) et la zone de drain (2) duquel on prévoit une zone d'anti-fusion (5) dont les paramètres sont choisis de telle manière que, avant l'application d'une tension de programmation (Vpp), l'électrode de grille (3) et la zone de drain (2) sont isolées l'une de l'autre par la zone d'anti-fusion (5) et que, par application de la tension de programmation (Vpp), qui est plus grande que la tension de service (Vdd), la zone d'anti-fusion (5) passe à son état à basse impédance, **caractérisée en ce que** la zone d'anti-fusion (5) et la zone de drain (2) sont en coïncidence.

2. Mémoire programmable selon la revendication précédente, **caractérisée en ce que** la zone d'anti-fusion (5) est réalisée en dioxyde de silicium.

3. Mémoire programmable selon l'une quelconque des revendications précédentes, **caractérisée en ce que** la zone d'anti-fusion (5) est moins épaisse que l'oxyde de la grille (6) du transistor (7).

4. Mémoire programmable selon l'une quelconque des revendications précédentes, **caractérisée en ce que** l'épaisseur de la zone d'anti-fusion (5) est comprise entre 8 et 12 nm.

5. Mémoire programmable selon l'une quelconque des revendications précédentes, **caractérisée en ce qu'**une résistance au claquage prédéterminée de la zone d'anti-fusion (5) peut être réglée au moyen du dopage de la zone de drain (2).

6. Mémoire programmable selon l'une quelconque des revendications précédentes, **caractérisée en ce que** le dopage de la zone de drain (2) est plus faible que le dopage de la zone de source (1) et, de préférence, égal au 1/10 du dopage de cette dernière.

7. Dispositif à circuit intégré comportant au moins une mémoire programmable selon l'une quelconque des revendications précédentes.

8. Dispositif à circuit intégré selon la revendication 7, **caractérisé en ce que** les mémoires sont disposées sous la forme d'une matrice, la tension de programmation (Vpp) et une tension de lecture (Vdd) pouvant être appliquées aux mémoires selon les lignes ou les colonnes.

9. Dispositif à circuit intégré selon la revendication , **caractérisé en ce que**, sur les mémoires qui ne doivent pas être programmées pour le moment, on peut appliquer une tension antagoniste (Vpp) empêchant la programmation.
